# EUROPÄISCHE PATENTANMELDUNG

(11) **EP 3 919 228 A1**
(43) Veröffentlichungstag der Anmeldung: **08.12.2021**
(21) Anmeldenummer: 21174868.6
(22) Anmeldetag: 20.05.2021
(51) Int. Cl.: B25B 21/00, B25B 23/00, G01R 31/54

(54) **VERFAHREN ZU EINER PRÜFUNG EINER BERÜHRUNG ZWEIER IN HOLZ GESCHRAUBTER, ELEKTRISCH LEITENDER SCHRAUBEN UND HANDSCHRAUBMASCHINE ZUR DURCHFÜHRUNG DES VERFAHRENS**

(30) Priorität: 02.06.2020 DE 102020114613
(71) Anmelder: fischerwerke GmbH & Co. KG, 72178 Waldachtal (DE)
(72) Erfinder: Heiß, Daniel, 71083 Herrenberg (DE)
(74) Vertreter: Suchy, Ulrich Johannes

(57) **Zusammenfassung**

Die Erfindung schlägt vor, zwei in Holz (2) geschraubte Schrauben (1) auf eine Berührung in dem Holz (2) zu prüfen, indem geprüft wird, ob die beiden Schrauben (1) elektrisch leitend verbunden sind.

## Beschreibung

Die Erfindung betrifft ein Verfahren zu einer Prüfung einer Berührung zweier in Holz geschraubter, elektrisch leitender Schrauben mit den Merkmalen des Oberbegriffs des Anspruchs 1 und eine Handschraubmaschine zur Durchführung des Verfahrens mit den Merkmalen des Oberbegriffs des Anspruchs 7.

Bei einem Einschrauben von Schrauben in Holz kann es vorkommen, dass sich die Schrauben berühren, wenn ihr an sich vorgesehener Abstand so klein ist, dass durch eine ungewollte Abweichung einer tatsächlichen Einschraublage der Schrauben von einer vorgesehenen Einschraublage die Schrauben einander im Holz berühren. Stößt eine Schraube beim Einschrauben in Holz gegen eine bereits in das Holz eingeschraubte Schraube und bewegt sich die einzuschraubende Schraube beim weiteren Einschrauben an der bereits eingeschraubten Schraube entlang, kann ein Gewinde der einzuschraubenden Schraube beschädigt oder von der einzuschraubenden Schraube abgetrennt, insbesondere abgeschert, werden. Die Beschädigung oder Abtrennung des Gewindes erstreckt sich beispielsweise von einer Schraubenspitze beziehungsweise von einem beim Einschrauben vorderen Ende der Schraube bis zu einer Berührungsstelle der später eingeschraubten Schraube mit der zuvor eingeschraubten Schraube. Beschädigt oder abgetrennt wird in diesem Fall also ein Abschnitt des Gewindes der einzuschraubenden Schraube, der für einen Halt der einzuschraubenden Schraube im Holz wichtig ist.

Aufgabe der Erfindung ist eine Prüfung, ob sich zwei in Holz geschraubte Schrauben berühren.

Diese Aufgabe wird erfindungsgemäß durch die Merkmale der Ansprüche 1 und 7 gelöst. Voraussetzung für das erfindungsgemäße Verfahren sind elektrisch leitende Schrauben. Sie werden erfindungsgemäß auf eine Berührung geprüft, indem geprüft wird, ob sie elektrisch leitend verbunden sind. Die Prüfung kann beispielsweise mit einem Durchgangsprüfer, einem Widerstandsmessgerät oder einem ähnlichen Gerät, das eine elektrisch leitende Verbindung prüfen kann, erfolgen. Bevorzugt ist aufgrund seines einfachen Aufbaus und der einfachen Handhabbarkeit ein Durchgangsprüfer. Ein Durchgangsprüfer ist ein elektrisches Prüfgerät, das prüft und - typischerweise durch ein akustisches und/oder optisches Signal - signalisiert, ob zwei Punkte elektrisch leitend miteinander verbunden sind. Die Prüfung kann erfolgen, wenn die elektrisch leitenden Schrauben bereits vollständig in Holz eingeschraubt sind oder während eines Einschraubens einer elektrisch leitenden Schraube in Holz, in das bereits eine oder mehrere weitere elektrisch leitende Schrauben eingeschraubt sind. Unter einer "eingeschraubten Schraube" ist eine Schraube zu verstehen, die sich bereits planmäßig eingeschraubt im Holz befindet. Unter einer "einzuschraubenden Schraube" ist eine Schraube zu verstehen, die noch in das Holz eingeschraubt werden muss oder in das Holz eingeschraubt wird.

Nicht durchführbar ist das erfindungsgemäße Verfahren, wenn die beiden Schrauben in anderer Weise als durch gegenseitige Berührung elektrisch leitend verbunden sind. Das ist beispielsweise der Fall, wenn ein elektrisch leitendes Lochblech aus Stahl mit den Schrauben am Holz befestigt wird. In diesem Fall kann beispielsweise mindestens eine der beiden Schrauben mit beispielsweise einer Kunststofftülle elektrisch von dem Lochblech isoliert werden.

Angewendet wird das Verfahren gemäß einem Aspekt der Erfindung bei Schrauben, die so nahe beieinander in das Holz geschraubt werden, dass eine Berührung der beiden Schrauben im Holz unbemerkt möglich ist, wenn die Schrauben ungewollt schräg in einem Winkel zu ihrer vorgesehenen Lage in das Holz geschraubt werden. Typischerweise wird das Verfahren bei Verbindungen des konstruktiven Holzbaus verwendet, also dann wenn die Schrauben tragende Funktion haben. Schraubenköpfe oder allgemein Stellen an einer Oberfläche des Holzes, an der die Schrauben angesetzt werden, können weit voneinander entfernt sein, wenn die Schrauben entgegengesetzt schräg in das Holz geschraubt werden, so dass sie im Holz nahe aneinander vorbei treten oder sich ungewollt berühren. Beispielsweise wird das Verfahren bei einem vorgegebenen Soll-Abstand der Schrauben gemäß einer Norm oder einer bauaufsichtlichen Zulassung wie beispielsweise einer europäischen technischen Zulassung (ETA; European Technical Approval oder European Technical Assessment) angewendet. Gemäß typischen Vorgaben wird ein Soll-Abstand von Längsachsen der Schrauben von nicht mehr als einem Doppelten oder Anderthalbfachen eines Gewindedurchmessers der Schrauben angewendet, wodurch ein Abstand von Hüllflächen der Gewinde der Schrauben nicht mehr als der Gewindedurchmesser oder eine Hälfte des Gewindedurchmessers beträgt, wenn die Schrauben wie vorgesehen in das Holz geschraubt sind. Der Soll-Abstand der Schrauben ist ein kleinster Abstand der Schrauben voneinander an einer Stelle im Holz, an der die Schrauben einander am nächsten sind, wenn die Schrauben wie vorgesehen in das Holz geschraubt sind. Bei diesen Abständen können die Schrauben einander unbemerkt im Holz berühren, wenn sie ungewollt in einem Winkel zu ihrer vorgesehenen Einschraublage in das Holz geschraubt werden beziehungsweise sind.

Eine Ausgestaltung der Erfindung sieht die Anwendung des Verfahrens für sogenannte einander "kreuzende" Schrauben vor. Damit sind Schrauben gemeint, die von beabstandeten Stellen an einer Oberfläche des Holzes in zueinander parallelen Ebenen in das Holz geschraubt werden, so dass senkrecht zu den parallelen Ebenen gesehen die beiden Schrauben einander kreuzen. Tatsächlich gehen die Schrauben aneinander vorbei, wenn der Abstand der parallelen Ebenen größer als der Gewindedurchmesser der Schrauben ist. Jedoch können die Schrauben einander berühren, wenn sie ungewollt in Richtung der jeweils anderen Schraube schräg aus den parallelen Ebenen heraustreten.

Vorzugsweise wird die elektrisch leitende Verbindung zwischen den Schrauben an Schraubenköpfen der beiden Schrauben und/oder mit einem Durchgangsprüfer oder einem elektrischen Widerstandsmessgerät geprüft.

Die Erfindung sieht zudem eine Handschraubmaschine zum Einschrauben der Schrauben in das Holz vor. Mit Handschraubmaschine ist insbesondere ein Akkuschrauber oder auch ein anderer Elektro-, Druckluft- oder sonstiger, handgehaltener Schrauber gemeint. Die Handschraubmaschine weist einen Durchgangsprüfer auf, mit dem eine elektrisch leitende Verbindung zwischen einer Schraubwerkzeugaufnahme der Handschraubmaschine und einem elektrischen Prüfkontakt geprüft werden kann. Die Schraubwerkzeugaufnahme ist beispielsweise eine Bitaufnahme für ein Schrauberbit oder ein Backenfutter. Die Prüfung kann vorzugsweise auch bei drehend angetriebener Schraubwerkzeugaufnahme erfolgen. Der Durchgangsprüfer steht in elektrisch leitendem Kontakt mit der einzuschraubenden Schraube, wenn ein in der Schraubwerkzeugaufnahme der Handschraubmaschine angeordnetes Schraubwerkzeug an beispielsweise einem Schraubenkopf der einzuschraubenden Schraube angesetzt ist.

Der elektrische Prüfkontakt ist beweglich gegenüber einem Gehäuse oder allgemein einem Gerätegrundkörper der Handschraubmaschine, so dass der elektrische Prüfkontakt in Kontakt mit beispielsweise einem Schraubenkopf einer in Holz eingeschraubten Schraube bringbar ist. Auf diese Weise kann während des Einschraubens geprüft werden, ob zwei in Holz geschraubte Schrauben aus elektrisch leitendem Material in elektrisch leitender Verbindung stehen. Auch kann detektiert werden, ob eine einzuschraubende Schraube auf eine bereits eingeschraubte Schraube trifft. Wird in diesem Fall der Einschraubvorgang sofort beendet, kann eine Beschädigung der einzuschraubenden Schraube meist verhindert werden. Die Handschraubmaschine kann derart ausgestaltet sein, dass in diesem Fall die Handschraubmaschine automatisch deaktiviert wird, um eine Beschädigung der einzuschraubenden Schraube zu vermeiden.

Der Durchgangsprüfer ist vorzugsweise fest an dem Gerätegrundkörper wie insbesondere dem Gehäuse der Handschraubmaschine angeordnet und beispielsweise in den Gerätegrundkörper beziehungsweise das Gehäuse der Handschraubmaschine integriert. Der Durchgangsprüfer kann auch lösbar am Gerätegrundkörper beziehungsweise dem Gehäuse der Handschraubmaschine angeordnet sein. Der elektrische Prüfkontakt kann mittels eines elektrischen Kabels mit dem Durchgangsprüfer verbunden sein. Möglich ist beispielsweise auch eine Funkverbindung wie Bluetooth.

Eine Ausgestaltung der Erfindung sieht vor, dass die Handschraubmaschine ein Elektroschrauber ist, der den Durchgangsprüfer mit elektrischem Strom versorgt. Das kann eine Stromversorgung für den Betrieb des Durchgangsprüfers und/oder eine Prüfspannung zwischen dem elektrischen Prüfkontakt und der Schraubwerkzeugaufnahme sein.

Die vorstehend in der Beschreibung genannten Merkmale und Merkmalskombinationen, Ausführungen und Ausgestaltungen der Erfindung, sowie die nachfolgend in der Figurenbeschreibung genannten und/oder in einer Figur gezeichneten Merkmale und Merkmalskombinationen sind nicht nur in der jeweils angegebenen oder gezeichneten Kombination, sondern auch in grundsätzlich beliebigen anderen Kombinationen oder aber einzeln verwendbar. Es sind Ausführungen der Erfindung möglich, die nicht alle Merkmale eines abhängigen Anspruchs aufweisen. Auch können einzelne Merkmale eines Anspruchs durch andere offenbarte Merkmale oder Merkmalskombinationen ersetzt werden. Ausführungen der Erfindung, die nicht alle Merkmale des oder der Ausführungsbeispiele, sondern einen grundsätzlich beliebigen Teil der gekennzeichneten Merkmale eines Ausführungsbeispiels gegebenenfalls in Kombination mit einem, mehreren oder allen Merkmalen eines oder mehrerer weiterer Ausführungsbeispiele aufweisen, sind möglich.

Die Erfindung wird nachfolgend anhand eines in der Zeichnung dargestellten Ausführungsbeispiels näher erläutert. Es zeigen:
- Figur 1: zwei in Holz eingeschraubte Schrauben in Seitenansicht zur Veranschaulichung und Erläuterung des Erfindungsgemäßen Verfahrens;
- Figur 2: die beiden Schrauben aus Figur 1 in Draufsicht; und
- Figur 3: eine Durchführung des erfindungsgemäßen Verfahrens mit einer Handschraubmaschine gemäß der Erfindung.

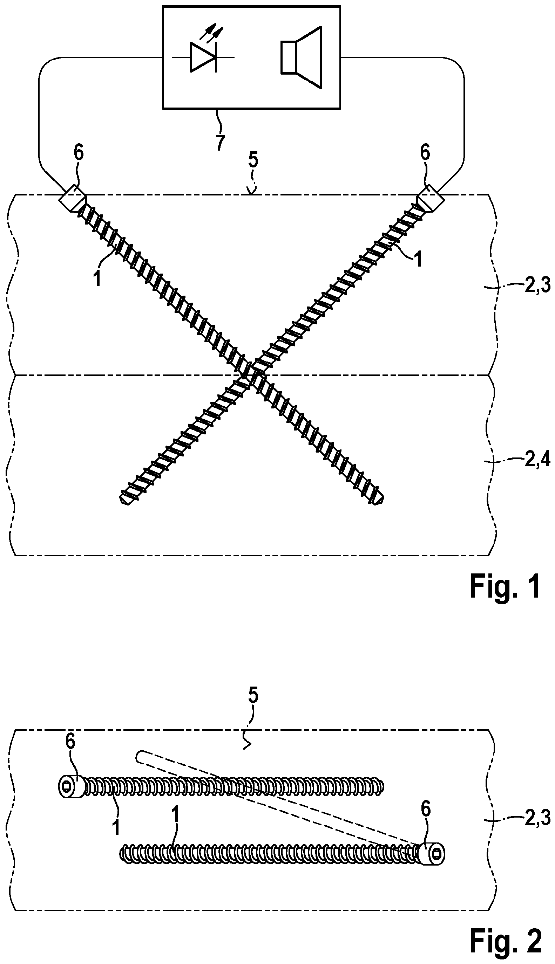

Figur 1 zeigt zwei Schrauben 1, die einander "kreuzend" in Holz 2 eingeschraubt sind. Es handelt sich um Holzbauschrauben aus Stahl, das heißt aus einem elektrisch leitenden Material. Das Holz 2 sind zwei aneinander anliegende Holzbalken, die mit den eingeschraubten Schrauben 1 miteinander verbunden sind. Die beiden mit den eingeschraubten Schrauben 1 verbundenen Holzbalken werden hier als erstes Holzbauteil 3 und als zweites Holzbauteil 4 bezeichnet.

Die beiden eingeschraubten Schrauben 1 sind einander entgegengesetzt schräg - im Ausführungsbeispiel mit Winkeln von 45° zu einer Oberfläche 5 des ersten Holzbauteils 3 - an zwei Stellen in das Holz 2 geschraubt. Ist das Einschrauben beendet, befinden sich Schraubenköpfe 6 der Schrauben 1 im Holz 2. Die beiden Stellen, an denen die Schrauben 1 in das Holz 2 eingeschraubt sind, sind zwar voneinander beabstandet, jedoch so nahe, dass sich die beiden Schrauben 1 in der Seitenansicht von Figur 1 zu kreuzen scheinen. Tatsächlich sind die beiden Schrauben 1, wie in der Draufsicht von Figur 2 zu sehen, in zwei zueinander parallelen Ebenen in das Holz 2 geschraubt, deren Abstand so groß ist, dass sich die Schrauben 1 im Holz 2 nicht berühren.

Jedoch kann es vorkommen, dass eine oder beide Schrauben 1 ungewollt schräg in Richtung der jeweils anderen Schraube 1 in das Holz 2 geschraubt wird/werden und sich die beiden Schrauben 1 im Holz 2 berühren, wie es in Figur 2 mit Strichlinien dargestellt ist. Das kann zur Folge haben, dass ein Schraubengewinde der Schraube 1, die später in das Holz 2 geschraubt wird, also der einzuschraubenden Schraube 1, beschädigt oder von der einzuschraubenden Schraube 1 getrennt wird, und zwar von einer Schraubenspitze bis zu einem Berühr- oder Kreuzungspunkt mit der früher in das Holz 2 geschraubten Schraube 1, also der bereits eingeschraubten Schraube 1. Das Schraubengewinde ist dadurch in einem vorderen Abschnitt der einzuschraubenden Schraube 1 beschädigt oder von der einzuschraubenden Schraube 1 abgetrennt, der für einen Halt der einzuschraubenden Schraube 1 im Holz 2 wichtig ist.

Ein durch eine bauaufsichtliche Zulassung, beispielsweise eine ETA (Europäische Technische Zulassung), für diese Schrauben 1 vorgegebener Soll-Abstand reicht nicht aus, um eine Berührung der eingeschraubten Schrauben 1 im Holz 2 auszuschließen. Ein typischer Soll-Abstand ist das 1,5-Fache eines Gewindeaußendurchmessers der eingeschraubten Schrauben 1, was einen Abstand von Hüllflächen der Schraubengewinde am Kreuzungspunkt der eingeschraubten Schrauben 1 von 0,5-mal dem Gewindeaußendurchmesser bedeutet. Der "Soll-Abstand" ist der Abstand der beiden gedachten, zueinander parallelen Ebenen, in denen Längsachsen der beiden eingeschraubten Schrauben 1 verlaufen sollen. Durch ein ungewolltes Einschrauben wenigstens einer der beiden Schrauben 1 schräg zu den parallelen Ebenen in Richtung der jeweils anderen Schraube 1 können die beiden eingeschraubten Schrauben 1 einander am Kreuzungspunkt berühren.

Deswegen sieht die Erfindung vor, die beiden Schrauben 1, die aus einem elektrisch leitenden Material bestehen, auf eine elektrisch leitende Verbindung zu prüfen. Berühren die beiden Schrauben 1 einander im Holz 2, sind sie elektrisch leitend verbunden, was mit dem erfindungsgemäßen Verfahren festgestellt wird. Berühren die beiden Schrauben 1 einander nicht, sind sie nicht elektrisch miteinander verbunden. Die Prüfung der elektrisch leitenden Verbindung kann durchgeführt werden, wenn die beiden Schrauben 1 in das Holz 2 eingeschraubt sind oder beim Einschrauben der einen Schraube 1, wenn die andere Schraube 1 bereits in das Holz 2 eingeschraubt ist.

Geprüft wird an der oder den in das Holz 2 eingeschraubten Schrauben 1 an deren Schraubenköpfen 6 und während des Einschraubens ebenfalls am Schraubenkopf 6 oder auch an anderer Stelle der Schraube 1. In Figur 1 werden die beiden in das Holz 2 eingeschraubten Schrauben 1 mittels eines Durchgangsprüfers 7 auf eine elektrisch leitende Verbindung geprüft. Der Durchgangsprüfer 7 ist ein elektrisches Messgerät zur Prüfung einer elektrisch leitenden Verbindung zwischen zwei Punkten wie beispielsweise den Schraubenköpfen 6. Alternativ kann beispielsweise ein elektrischer Widerstand zwischen den beiden eingeschraubten Schrauben 1 mit einem Widerstandsmessgerät geprüft werden (nicht dargestellt).

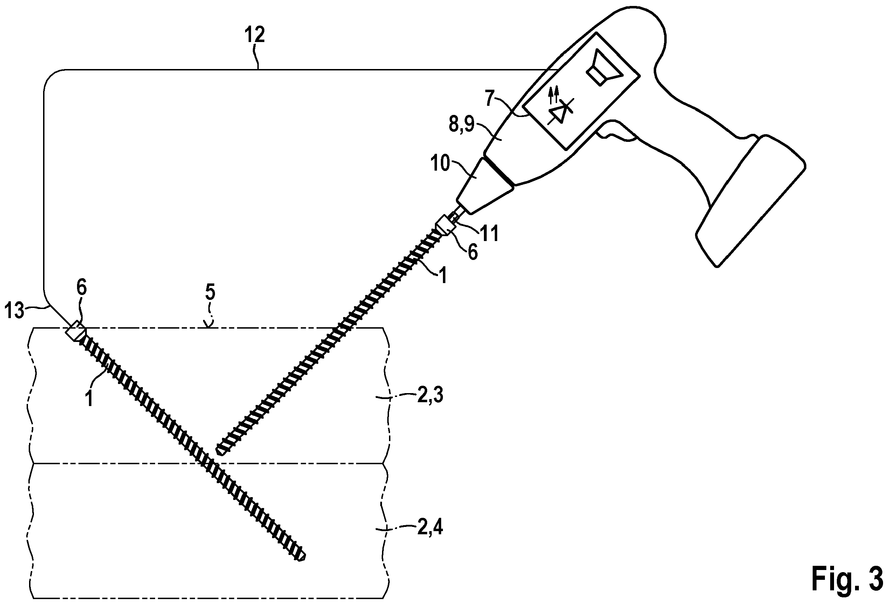

In Figur 3 ist eine Schraube 1 schräg in Holz 2 eingeschraubt und es wird eine zweite Schraube 1 mit einem Akkuschrauber, der hier als Handschraubmaschine 8 bezeichnet wird, entgegengesetzt schräg in das Holz 2 eingeschraubt, so dass sich die beiden Schrauben 1 in der Seitenansicht zu kreuzen scheinen. Die Handschraubmaschine 8 weist einen Durchgangsprüfer 7 auf, der im Ausführungsbeispiel in ein Gehäuse der Handschraubmaschine 8 integriert ist, das hier allgemein als Gerätegrundkörper 9 bezeichnet wird. Der Durchgangsprüfer 7 kann auch fest oder abnehmbar an dem Gerätegrundkörper 9 der Handschraubmaschine 8 angeordnet sein.

Eine Bitaufnahme als Schraubwerkzeugaufnahme 10 ist an den Durchgangsprüfer 7 angeschlossen, so dass sie beziehungsweise ein in sie eingesetztes Schrauberbit 11 einen Punkt zum Prüfen der elektrisch leitenden Verbindung bildet. Anstelle der Bitaufnahme kann die Handschraubmaschine 8 beispielsweise ein Backenfutter, in das ein Schraubendrehwerkzeug eingespannt werden kann, als Schraubwerkzeugaufnahme aufweisen (nicht dargestellt).

Über ein Kabel 12 ist ein elektrischer Prüfkontakt 13 an den Durchgangsprüfer 7 der Handschraubmaschine 8 angeschlossen, so dass während des Einschraubens der Schraube 1 in das Holz 2 mit der Handschraubmaschine 8 eine Berührung mit einer zuvor in das Holz 2 eingeschraubten Schraube 1 geprüft werden kann, in dem geprüft wird, ob die beiden Schrauben 1 elektrisch leitend verbunden sind. Die Handschraubmaschine 8 versorgt den Durchgangsprüfer 7 mit elektrischem Strom zu seinem Betrieb und stellt außerdem eine elektrische Spannung zur Prüfung der elektrisch leitenden Verbindung zur Verfügung. Anstelle der Verbindung mit dem Kabel 12 kann der Prüfkontakt 13 auch eine Funkverbindung beispielsweise mit Bluetooth mit dem Durchgangsprüfer 7 der Handschraubmaschine 8 aufweisen (nicht dargestellt). In diesem Fall benötigt der Prüfkontakt 13 eine eigene Stromversorgung.

### Bezugszeichenliste

- 1: Schraube
- 2: Holz
- 3: erstes Holzbauteil
- 4: zweites Holzbauteil
- 5: Oberfläche
- 6: Schraubenkopf
- 7: Durchgangsprüfer
- 8: Handschraubmaschine
- 9: Gerätegrundkörper
- 10: Schraubwerkzeugaufnahme
- 11: Schrauberbit
- 12: Kabel
- 13: Prüfkontakt

## Patentansprüche

1. Verfahren zu einer Prüfung einer Berührung zweier in Holz (2) geschraubter, elektrisch leitender Schrauben (1) auf Berührung der beiden Schrauben (1) im Holz (2), **dadurch gekennzeichnet, dass** die beiden in das Holz (2) geschraubten Schrauben (1) auf eine elektrisch leitende Verbindung zwischen den beiden Schrauben (1) geprüft werden.

2. Verfahren nach Anspruch 1, **dadurch gekennzeichnet, dass** die beiden Schrauben (1) mit einem Soll-Abstand, beispielsweise nach ETA, in das Holz (2) geschraubt sind.

3. Verfahren nach Anspruch 1 oder 2, **dadurch gekennzeichnet, dass** die beiden Schrauben (1) jeweils in zwei zueinander parallelen Ebenen und senkrecht zu den beiden zueinander parallelen Ebenen gesehen einander kreuzend in das Holz (2) geschraubt sind.

4. Verfahren nach einem oder mehreren der Ansprüche 1 bis 3, **dadurch gekennzeichnet, dass** die beiden Schrauben (1) zwei Holzbauteile (3, 4) verbinden.

5. Verfahren nach einem oder mehreren der vorhergehenden Ansprüche, **dadurch gekennzeichnet, dass** die elektrisch leitende Verbindung zwischen Schraubenköpfen (6) der beiden Schrauben (1) geprüft wird.

6. Verfahren nach einem oder mehreren der vorhergehenden Ansprüche, **dadurch gekennzeichnet, dass** die elektrisch leitende Verbindung zwischen den beiden Schrauben (1) mit einem Durchgangsprüfer (7) oder einem elektrischen Widerstandsmessgerät geprüft wird.

7. Handschraubmaschine zu einem Einschrauben einer Schraube (1) in ein Holzbauteil (3, 4) zu einer Durchführung des Verfahrens nach einem oder mehreren der vorhergehenden Ansprüche, wobei die Handschraubmaschine (8) einen Gerätegrundkörper (9) aufweist, **dadurch gekennzeichnet, dass** die Handschraubmaschine (8) einen Durchgangsprüfer (7) aufweist, mit dem eine elektrisch leitende Verbindung zwischen einer Schraubwerkzeugaufnahme (11) der Handschraubmaschine (8) auch bei einem Drehantrieb der Schraubwerkzeugaufnahme (10) und einem elektrischen Prüfkontakt (13), der in Bezug auf den Gerätegrundkörper (9) der Handschraubmaschine (8) beweglich ist, so dass er in elektrisch leitenden Kontakt mit einer in Holz (2) geschraubten Schraube (1) bringbar ist, geprüft werden kann.

8. Handschraubmaschine nach Anspruch 7, **dadurch gekennzeichnet, dass** der Durchgangsprüfer (7) fest oder abnehmbar an dem Gerätegrundkörper (9) der Handschraubmaschine (8) angeordnet ist und/oder dass der elektrische Prüfkontakt (13) mit einem elektrischen Kabel (12) oder einer Funkverbindung mit dem Durchgangsprüfer (7) verbunden ist.

9. Handschraubmaschine nach Anspruch 7 oder 8, **dadurch gekennzeichnet, dass** die Handschraubmaschine (8) ein Elektroschrauber ist, der den Durchgangsprüfer (7) mit elektrischem Strom für die Prüfung der elektrisch leitenden Verbindung versorgt.
